# EUROPEAN PATENT APPLICATION

(11) **EP 4 560 877 A1**
(43) Date of publication of application: **28.05.2025**
(21) Application number: 24194212.7
(22) Date of filing: 12.08.2024
(51) Int. Cl.: H02J 9/06, E04H 5/04

(54) **PREFABRICATED ALTERNATING-CURRENT INTEGRATED POWER MODULE**

(30) Priority: 24.11.2023 CN 202323213443 U
(71) Applicant: Vertiv Tech Co., Ltd., Guangdong 518055 (CN)
(72) Inventor: GAO, Yan, Jiangmen, 529051 (CN); HE, Yong, Shenzhen, 518055 (CN); TU, Shiyang, Jiangmen, 529051 (CN); HU, Linfeng, Jiangmen, 529051 (CN); LI, Wenpei, Jiangmen, 529051 (CN); LI, Junhai, Jiangmen, 529051 (CN); TAN, Shetang, Jiangmen, 529051 (CN)
(74) Representative: Morrall, Jonathan Ian McLachlan

(57) **Abstract**

Disclosed is a prefabricated alternating-current integrated power module, including a modular low-voltage input and bus coupling device, a low-voltage compensation device, a maintenance bypass device, an uninterruptable power supply power module device and an uninterruptable power supply feed device, which are detachably connected along a horizontal direction. All the devices and connection components among the devices of the prefabricated alternating-current integrated power module are prefabricated in the factory, greatly reducing the footprint, and achieving rapid delivery and deployment at the customer's site. With the prefabricated alternating-current integrated power module, the uninterruptable power supply power module device can be repaired or replaced without powering off the system. Further, capacity expansion and quick deployment can be performed without powering off the system, eliminating the impact of power outage operation.

## Description

### FIELD

The present disclosure relates to the technical field of power supply, and in particular to a prefabricated alternating-current integrated power module.

### BACKGROUND

According to conventional power distribution solutions, a medium-voltage power distribution device, a transformer device, a low-voltage power distribution device and an uninterruptible power supply are independent components that are not interconnected with each other and are only physically placed together. These devices have different appearances, and cabinets cannot be connected with each other based on the frameworks of the devices. Electrical energy transmission can only be performed between devices via cables, resulting in a large footprint, a long on-site delivery time period, and difficult maintenance and repair. In addition, according to the conventional solutions, uninterrupted maintenance and repair on the uninterruptible power supply are usually not supported. For specific scenarios, such as a power distribution system of a bank and a power distribution system of an important data center, a power outage may cause a catastrophic consequence, resulting in financial losses and a significant impact on customer service and operations. Therefore, the limitations of the conventional power distribution solutions are particularly apparent in these scenarios.

### SUMMARY

A technical object to be achieved by the present disclosure is to provide a prefabricated alternating-current integrated power module, in which multiple devices are integrated, and for which, expansion and quick deployment could be performed without powering off the system.

According to the present disclosure, the following technical solutions are provided.

A prefabricated alternating-current integrated power module is provided. The prefabricated alternating-current integrated power module includes: a modular low-voltage input and bus coupling device, a low-voltage compensation device, a maintenance bypass device, an uninterruptable power supply power module device and an uninterruptable power supply feed device. The low-voltage input and bus coupling device, the low-voltage compensation device, the maintenance bypass device, the uninterruptable power supply power module device and the uninterruptable power supply feed device are detachably connected along a horizontal direction.

In an embodiment, the prefabricated alternating-current integrated power module further includes a modular transformer device. The transformer device is detachably connected with the low-voltage input and bus coupling device, the low-voltage compensation device, the maintenance bypass device, the uninterruptable power supply power module device and the uninterruptable power supply feed device along the horizontal direction.

In an embodiment, the prefabricated alternating-current integrated power module further includes a modular medium-voltage input switch device. The medium-voltage input switch device is detachably connected with the transformer device, the low-voltage input and bus coupling device, the low-voltage compensation device, the maintenance bypass device, the uninterruptable power supply power module device and the uninterruptable power supply feed device along the horizontal direction.

In an embodiment, a cabinet connection hole is disposed on a side wall of a framework of each of the medium-voltage input switch device, the transformer device, the low-voltage input and bus coupling device, the low-voltage compensation device, the maintenance bypass device, the uninterruptable power supply power module device and the uninterruptable power supply feed device, for detachably connecting the medium-voltage input switch device, the transformer device, the low-voltage input and bus coupling device, the low-voltage compensation device, the maintenance bypass device, the uninterruptable power supply power module device and the uninterruptable power supply feed device with each other.

In an embodiment, an independent bus room is arranged in each of the medium-voltage input switch device, the transformer device, the low-voltage input and bus coupling device, the low-voltage compensation device, the maintenance bypass device, the uninterruptable power supply power module device and the uninterruptable power supply feed device, and bus rooms are communicated with each other after detachable connection.

In an embodiment, for a bus room in which multiple groups of buses are placed, a partition plate is arranged in the bus room for dividing the bus room into independent compartments, each for accommodating a respective one group of the multiple groups of buses.

In an embodiment, a secondary circuit compartment is arranged in each of the medium-voltage input switch device, the transformer device, the low-voltage input and bus coupling device, the low-voltage compensation device, the maintenance bypass device, the uninterruptable power supply power module device and the uninterruptable power supply feed device, the secondary circuit compartment is arranged below the bus room, and secondary circuit compartments are communicated with each other after the detachable connection.

In an embodiment, the prefabricated alternating-current integrated power module further includes an integrated module base. More than one of the modular medium-voltage input switch device, the transformer device, the low-voltage input and bus coupling device, the low-voltage compensation device, the maintenance bypass device, the uninterruptable power supply power module device and the uninterruptable power supply feed device are detachably installed on the integrated module base.

In an embodiment, a bottom fixing hole is disposed on a bottom plate of a framework of each of the medium-voltage input switch device, the transformer device, the low-voltage input and bus coupling device, the low-voltage compensation device, the maintenance bypass device, the uninterruptable power supply power module device and the uninterruptable power supply feed device for detachably connecting the medium-voltage input switch device, the transformer device, the low-voltage input and bus coupling device, the low-voltage compensation device, the maintenance bypass device, the uninterruptable power supply power module device and the uninterruptable power supply feed device to the integrated module base.

In an embodiment, the medium-voltage input switch device, the transformer device, the low-voltage input and bus coupling device, the low-voltage compensation device, the maintenance bypass device, the uninterruptable power supply power module device and the uninterruptable power supply feed device are arranged in sequence along the horizontal direction.

In an embodiment, each of the medium-voltage input switch device, the transformer device, the low-voltage input and bus coupling device, the low-voltage compensation device, the maintenance bypass device, the uninterruptable power supply power module device and the uninterruptable power supply feed device is arranged with a grounding component at bottom. Grounding components are communicated with each other to form a grounding system after detachable connection.

In an embodiment, the uninterruptable power supply power feed device is arranged with an independent cable compartment for cable entry and exit.

The following beneficial effects can be achieved according to the present disclosure.

In the prefabricated alternating-current integrated power module according to the present disclosure, the modular low-voltage input and bus coupling device, the low-voltage compensation device, the maintenance bypass device, the uninterruptable power supply power module device and the uninterruptable power supply feed device are integrated together. All the devices and connection components among the devices are prefabricated in the factory, greatly reducing the footprint, and achieving rapid delivery and deployment at the customer's site. With the prefabricated alternating-current integrated power module, the uninterruptable power supply power module device can be repaired or replaced without powering off the system. Further, capacity expansion and quick deployment can be performed without powering off the system, eliminating the impact of power outage operation. In addition, the operation time for maintenance, replacement and expansion is not limited.

### BRIEF DESCRIPTION OF THE DRAWINGS

Figure 1 is a main view of a prefabricated alternating-current integrated power module according to in an embodiment of the present disclosure;
Figure 2 is a schematic diagram of a three-dimensional structure of a prefabricated alternating-current integrated power module according to an embodiment of the present disclosure;
Figure 3 is a partially enlarged schematic diagram illustrating part A shown in Figure 2;
Figure 4 is a schematic diagram of a three-dimensional structure of a prefabricated alternating-current integrated power module with opening cabinet doors according to an embodiment of the present disclosure; and
Figure 5 is a partially enlarged schematic diagram illustrating part B shown in Figure 2.

### Reference numerals are listed as follows:

| | | | |
|---|---|---|---|
| 1 | medium-voltage input switch device | 2 | transformer device |
| 3 | low-voltage input and bus coupling device | 4 | low-voltage compensation device |
| 5 | maintenance bypass device | 6 | uninterruptable power supply power module device |
| 7 | uninterruptable power supply feed device | 8 | integrated module base |
| 9 | cable compartment | 10 | secondary circuit compartment |
| 11 | grounding component | 12 | bus room |
| 122 | independent compartment | 14 | cabinet connection hole |
| 15 | bottom fixing hole | | |

### DETAILED DESCRIPTION

In order to clarify the technical problem to be solved, the technical solutions, and the beneficial effects of the present disclosure, the present disclosure is described below in detail in conjunction with the drawings and embodiments. It should be understood that the embodiments described herein are only intended to explain the present disclosure, rather than limiting the present disclosure.

It should be noted that when a component is "fixed" or "arranged" on another component, the component may be directly or indirectly arranged on the other component. When a component is "connected to" another component, the component may be directly or indirectly connected to the other component.

It should be understood that the orientation or position relationship indicated by the terms "length", "width", "up", "down", "front", "back", "left", "right", "vertical", "horizontal", "top", "bottom", "inside", "outside" and the like is based on the orientation or position relationship shown in accompanying drawings. These terms are used for the convenience of describing the present disclosure and simplifying the description, rather than indicating or implying that a device or a component referred to must have a specific orientation or be constructed and operated in a specific orientation, therefore these terms should be understood as a limitation of the present disclosure.

In addition, the terms "first" and "second" are only used for description, and should not be understood as indicating or implying relative importance or implying the number of the indicated technical features. Therefore, each of the features defined by "first" and "second" may explicitly or implicitly include one or more features. In the description of the present disclosure, "multiple" indicates two or more, unless specifically defined otherwise.

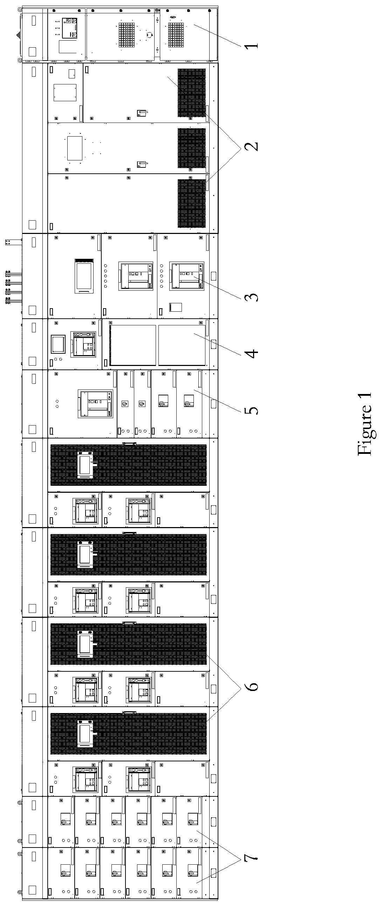

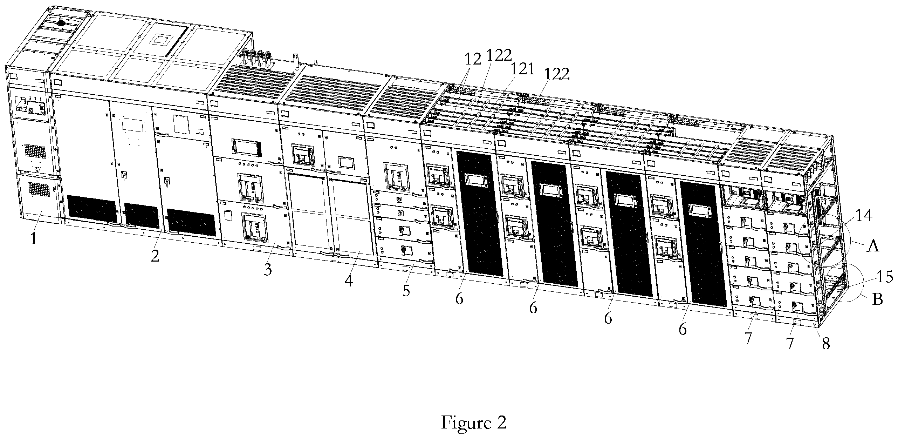

References are made to Figure 1 and Figure 2, which show preferred embodiments of the present disclosure. The prefabricated alternating-current integrated power module includes: a modular low-voltage input and bus coupling device 3, a low-voltage compensation device 4, a maintenance bypass device 5, an uninterruptable power supply power module device 6 and an uninterruptable power supply feed device 7. The low-voltage input and bus coupling device 3, the low-voltage compensation device 4, the maintenance bypass device 5, the uninterruptable power supply power module device 6 and the uninterruptable power supply feed device 7 may be detachably connected along a horizontal direction.

In the prefabricated alternating-current integrated power module according to the present disclosure, the modular low-voltage input and bus coupling device 3, the low-voltage compensation device 4, the maintenance bypass device 5, the uninterruptable power supply power module device 6 and the uninterruptable power supply feed device 7 are integrated together. All the devices and connection components among the devices are prefabricated in the factory, greatly reducing the footprint, and achieving rapid delivery and deployment at the customer's site. With the prefabricated alternating-current integrated power module, the uninterruptable power supply power module device 6 can be repaired or replaced without powering off the system. Further, capacity expansion and quick deployment can be performed without powering off the system, eliminating the impact of power outage operation. In addition, the operation time for maintenance, replacement and expansion is not limited. The components mentioned-above are described below in further detail.

As shown in Figure 1, the low-voltage input and bus coupling device 3, the low-voltage compensation device 4, the maintenance bypass device 5, the uninterruptable power supply power module device 6 and the uninterruptable power supply feed device 7 may be arranged together from left to right, or may be arranged together from right to left as shown in Figure 2. In another embodiment of the present disclosure, the positions of the low-voltage compensation device 4, the maintenance bypass device 5, the uninterruptable power supply power module device 6 and the uninterruptable power supply feed device 7 may be interchanged.

One or more uninterruptable power supply power module devices 6 and one or more uninterruptable power supply feed devices 7 may be arranged. In a case that multiple uninterruptable power supply power module devices 6 and multiple uninterruptable power supply feed devices 7 are arranged, the multiple uninterruptable power supply power module devices 6 are arranged together in sequence, and the multiple uninterruptable power supply feed devices 7 are arranged together in sequence.

In an embodiment of the present application, as shown in Figure 1 and Figure 2, the prefabricated alternating-current integrated power module further includes a modular transformer device 2. Multiple transformer devices 2 may be arranged. One or more transformer devices 2 are detachably connected with the low-voltage input and bus coupling device 3, the low-voltage compensation device 4, the maintenance bypass device 5, the uninterruptable power supply power module device 6 and the uninterruptable power supply feed device 7 in sequence along the horizontal direction.

In another embodiment of the present application, as shown in Figure 1 and Figure 2, the prefabricated alternating-current integrated power module further includes a modular medium-voltage input switch device 1. The medium-voltage input switch device 1 is detachably connected with the transformer device 2, the low-voltage input and bus coupling device 3, the low-voltage compensation device 4, the maintenance bypass device 5, the uninterruptable power supply power module device 6 and the uninterruptable power supply feed device 7 in sequence along the horizontal direction.

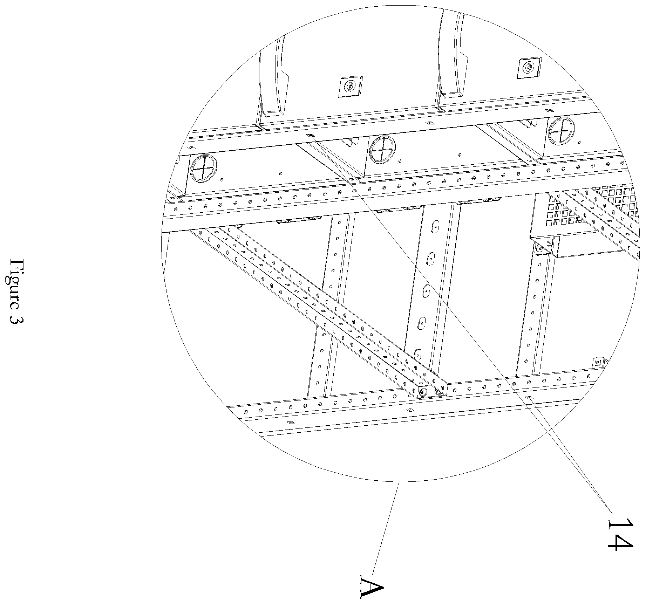

In order to detachably connect the devices in the prefabricated alternating-current integrated power module together, as shown in Figure 3, the prefabricated alternating-current integrated power module further includes cabinet connection holes 14. The cabinet connection holes 14 are disposed on side walls of frameworks of the medium-voltage input switch device 1, the transformer device 2, the low-voltage input and bus coupling device 3, the low-voltage compensation device 4, the maintenance bypass device 5, the uninterruptable power supply power module device 6 and the uninterruptable power supply feed device 7. The medium-voltage input switch device 1, the transformer device 2, the low-voltage input and bus coupling device 3, the low-voltage compensation device 4, the maintenance bypass device 5, the uninterruptable power supply power module device 6 and the uninterruptable power supply feed device 7 are connected tightly through the cabinet connection holes 14 to form a whole, and then are fixed on a base or a flat cement ground at the delivery site.

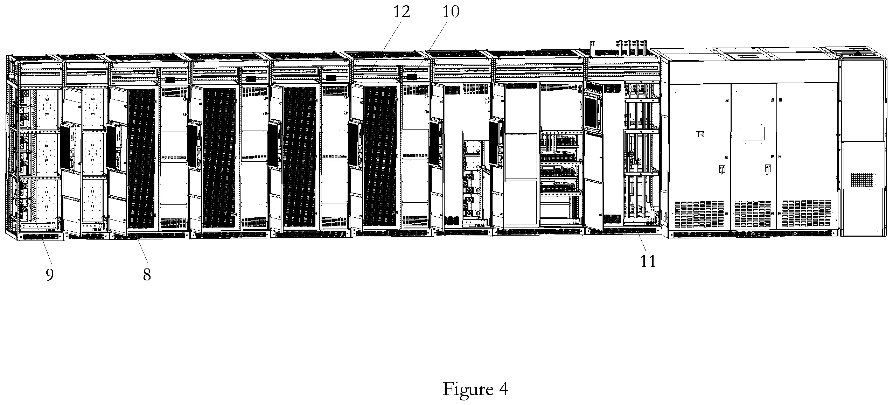

In another embodiment of the present application, as shown in Figure 4, the prefabricated alternating-current integrated power module further includes an integrated module base 8. More than one of the modular medium-voltage input switch device 1, the transformer device 2, the low-voltage input and bus coupling device 3, the low-voltage compensation device 4, the maintenance bypass device 5, the uninterruptable power supply power module device 6 and the uninterruptable power supply feed device 7 are detachably installed on the integrated module base 8. Based on the integrated module base 8, the modular medium-voltage input switch device 1, the transformer device 2, the low-voltage input and bus coupling device 3, the low-voltage compensation device 4, the maintenance bypass device 5, the uninterruptable power supply power module device 6 and the uninterruptable power supply feed device 7 form a whole.

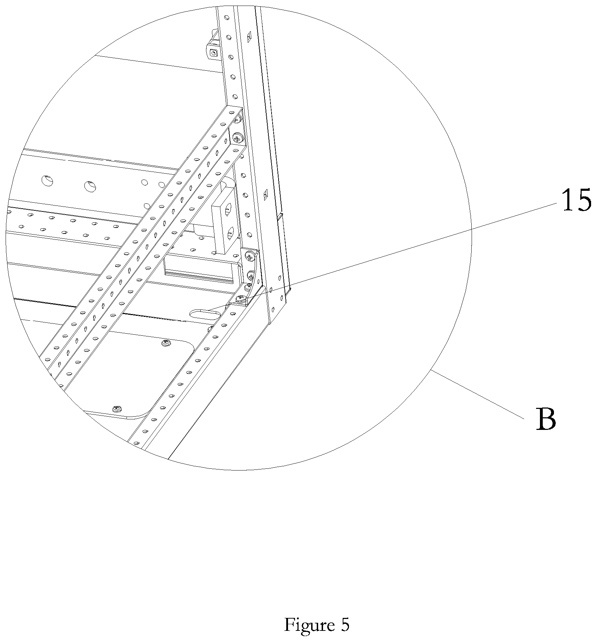

In order to detachably connect the devices of the prefabricated alternating-current integrated power module to the integrated module base 8, as shown in Figure 5, the prefabricated alternating-current integrated power module further includes bottom fixing holes 15. The bottom fixing holes 15 are disposed on bottom plates of frameworks of the medium-voltage input switch device 1, the transformer device 2, the low-voltage input and bus coupling device 3, the low-voltage compensation device 4, the maintenance bypass device 5, the uninterruptable power supply power module device 6 and the uninterruptable power supply feed device 7. The medium-voltage input switch device 1, the transformer device 2, the low-voltage input and bus coupling device 3, the low-voltage compensation device 4, the maintenance bypass device 5, the uninterruptable power supply power module 6 and the uninterruptable power supply feed device 7 are tightly connected to the integrated module base 8 through the bottom fixing holes 15 to form a whole.

The medium-voltage input switch device 1, the transformer device 2, the low-voltage input and bus coupling device 3, the low-voltage compensation device 4, the maintenance bypass device 5, the uninterruptable power supply power module device 6, the uninterruptable power supply feed device 7 and the integrated module base 8 may all be prefabricated in the factory, separately packaged and transported, and quickly assembled and delivered at the customer site; or may be assembled in the factory and then delivered as a whole to the customer.

Buses of the medium-voltage input switch device 1, the transformer device 2, the low-voltage input and bus coupling device 3, the low-voltage compensation device 4, the maintenance bypass device 5, the uninterruptable power supply power module device 6 and the uninterruptable power supply feed device 7 are connected by copper bars. Each of the medium-voltage input switch device 1, the transformer device 2, the low-voltage input and bus coupling device 3, the low-voltage compensation device 4, the maintenance bypass device 5, the uninterruptable power supply power module device 6 and the uninterruptable power supply feed device 7 is arranged with an independent bus room 12. As shown in Figure 4 and Figure 2, bus rooms 12 are arranged at tops of the devices, and the bus rooms 12 are communicated with each other after detachable connection. Buses of adjacent devices are connected by a copper bar or a cable.

As shown in Figure 2, for a device arranged with multiple groups of buses, the bus room 12 is arranged with a partition plate 121 for dividing the bus room 12 into independent compartments 122, each for accommodating a respective one group of the multiple groups of buses, so that the multiple groups of buses are independent of each other.

As shown in Figure 4, each of the medium-voltage input switch device 1, the transformer device 2, the low-voltage input and bus coupling device 3, the low-voltage compensation device 4, the maintenance bypass device 5, the uninterruptable power supply power module device 6 and the uninterruptable power supply feed device 7 is arranged with an independent secondary circuit compartment 10, and the secondary circuit compartment 10 is arranged below the bus room 12. Multiple secondary circuit compartments 10 are communicated with each other after the detachable connection.

The uninterruptable power supply feed device 7 is arranged with an independent cable compartment 9 for cable entry and exit. Cables may entry and exit the cable compartment 9 both from the top of the cable compartment 9 and from the bottom of the cable compartment 9. The cable compartment 9 is arranged at an outer side of the uninterruptable power supply feed device 7 and is in a slender box shape, and a length direction of the cable compartment 9 is consistent with a height direction of the uninterruptable power supply feed device 7.

The bus room 12, the secondary circuit compartment 10 and the cable compartment 9 each is arranged in an isolated state, not affecting each other during maintenance and repair. The isolated state indicates that the bus room 12, the secondary circuit compartment 10 and the cable compartment 9 are physically isolated by frameworks and partition plates, so that the bus room 12, the secondary circuit compartment 10 and the cable compartment 9 are independently arranged with each other and with other components.

As shown in Figure 4, each of the medium-voltage input switch device 1, the transformer device 2, the low-voltage input and bus coupling device 3, the low-voltage compensation device 4, the maintenance bypass device 5, the uninterruptable power supply power module device 6 and the uninterruptable power supply feed device 7 is arranged with a grounding component 11 at bottom, and the grounding component 11 is connected to the framework of the corresponding device. Multiple grounding components 11 are communicated with each other after detachable connection to form a grounding system. In a preferable embodiment, the multiple grounding components 11 are connected together with copper bars.

In the prefabricated alternating-current integrated power module according to the present disclosure, the modular low-voltage input and bus coupling device 3, the low-voltage compensation device 4, the maintenance bypass device 5, the uninterruptable power supply power module device 6 and the uninterruptable power supply feed device 7 are integrated together. All the devices and connection components among the devices are prefabricated in the factory, greatly reducing the footprint, and achieving rapid delivery and deployment at the customer's site. With the prefabricated alternating-current integrated power module, the uninterruptable power supply power module device 6 can be repaired or replaced without powering off the system. Further, capacity expansion and quick deployment can be performed without powering off the system, eliminating the impact of power outage operation. In addition, the operation time for maintenance, replacement and expansion is not limited.

The contents described above are only preferred embodiment of the present disclosure. Those have ordinary skill in the art may make various modifications in specific implementations and application scopes based on the idea of the present disclosure. As long as not deviating from the spirit of the present disclosure, these modifications fall within the protection scope of the present disclosure.

## Claims

1. A prefabricated alternating-current integrated power module, **characterized by** comprising: a modular low-voltage input and bus coupling device (3), a low-voltage compensation device (4), a maintenance bypass device (5), an uninterruptable power supply power module device (6), and an uninterruptable power supply feed device (7), wherein the low-voltage input and bus coupling device (3), the low-voltage compensation device (4), the maintenance bypass device (5), the uninterruptable power supply power module device (6) and the uninterruptable power supply feed device (7) are detachably connected along a horizontal direction.

2. The prefabricated alternating-current integrated power module according to claim 1, **characterized by** further comprising a modular transformer device (2), wherein the transformer device (2) is detachably connected with the low-voltage input and bus coupling device (3), the low-voltage compensation device (4), the maintenance bypass device (5), the uninterruptable power supply power module device (6) and the uninterruptable power supply feed device (7) along the horizontal direction.

3. The prefabricated alternating-current integrated power module according to claim 2, **characterized by** further comprising a modular medium-voltage input switch device (1), wherein the medium-voltage input switch device (1) is detachably connected with the transformer device (2), the low-voltage input and bus coupling device (3), the low-voltage compensation device (4), the maintenance bypass device (5), the uninterruptable power supply power module device (6) and the uninterruptable power supply feed device (7) along the horizontal direction.

4. The prefabricated alternating-current integrated power module according to claim 3, **characterized in that**, a cabinet connection hole (14) is disposed on a side wall of a framework of each of the medium-voltage input switch device (1), the transformer device (2), the low-voltage input and bus coupling device (3), the low-voltage compensation device (4), the maintenance bypass device (5), the uninterruptable power supply power module device (6) and the uninterruptable power supply feed device (7), for detachably connecting the medium-voltage input switch device (1), the transformer device (2), the low-voltage input and bus coupling device (3), the low-voltage compensation device (4), the maintenance bypass device (5), the uninterruptable power supply power module device (6) and the uninterruptable power supply feed device (7) with each other.

5. The prefabricated alternating-current integrated power module according to claim 3, **characterized in that**, an independent bus room (12) is arranged in each of the medium-voltage input switch device (1), the transformer device (2), the low-voltage input and bus coupling device (3), the low-voltage compensation device (4), the maintenance bypass device (5), the uninterruptable power supply power module device (6) and the uninterruptable power supply feed device (7), and a plurality of the bus rooms (12) are communicated with each other after detachable connection.

6. The prefabricated alternating-current integrated power module according to claim 5, **characterized in that**, for the bus room (12) in which a plurality groups of buses are placed, a partition plate (121) is arranged in the bus room (12) for dividing the bus room (12) into independent compartments (122), each for accommodating a respective one group of the plurality groups of buses.

7. The prefabricated alternating-current integrated power module according to claim 5, **characterized in that**, an independent secondary circuit compartment (10) is arranged in each of the medium-voltage input switch device (1), the transformer device (2), the low-voltage input and bus coupling device (3), the low-voltage compensation device (4), the maintenance bypass device (5), the uninterruptable power supply power module device (6) and the uninterruptable power supply feed device (7), the secondary circuit compartment (10) is arranged below the bus room (12), and a plurality of the secondary circuit compartments (10) are communicated with each other after the detachable connection.

8. The prefabricated alternating-current integrated power module according to claim 3, **characterized by** further comprising an integrated module base (8), wherein more than one of the modular medium-voltage input switch device (1), the transformer device (2), the low-voltage input and bus coupling device (3), the low-voltage compensation device (4), the maintenance bypass device (5), the uninterruptable power supply power module device (6) and the uninterruptable power supply feed device (7) are detachably installed on the integrated module base (8).

9. The prefabricated alternating-current integrated power module according to claim 8, **characterized in that**, a bottom fixing hole (15) is disposed on a bottom plate of a framework of each of the medium-voltage input switch device (1), the transformer device (2), the low-voltage input and bus coupling device (3), the low-voltage compensation device (4), the maintenance bypass device (5), the uninterruptable power supply power module device (6) and the uninterruptable power supply feed device (7), for detachably connecting the medium-voltage input switch device (1), the transformer device (2), the low-voltage input and bus coupling device (3), the low-voltage compensation device (4), the maintenance bypass device (5), the uninterruptable power supply power module device (6) and the uninterruptable power supply feed device (7) to the integrated module base (8).

10. The prefabricated alternating-current integrated power module according to any one of claims 3 to 9, **characterized in that**, the medium-voltage input switch device (1), the transformer device (2), the low-voltage input and bus coupling device (3), the low-voltage compensation device (4), the maintenance bypass device (5), the uninterruptable power supply power module device (6) and the uninterruptable power supply feed device (7) are arranged in sequence along the horizontal direction.

11. The prefabricated alternating-current integrated power module according to any one of claims 3 to 9, **characterized in that**, each of the medium-voltage input switch device (1), the transformer device (2), the low-voltage input and bus coupling device (3), the low-voltage compensation device (4), the maintenance bypass device (5), the uninterruptable power supply power module device (6) and the uninterruptable power supply feed device (7) is arranged with a grounding component (11) at bottom, and a plurality of the grounding components (11) are communicated with each other to form a grounding system after detachable connection.

12. The prefabricated alternating-current integrated power module according to any one of claims 3 to 9, **characterized in that**, the uninterruptable power supply feed device (7) is arranged with an independent cable compartment (9) for cable entry and exit.
